# EUROPEAN PATENT APPLICATION

(11) **EP 4 770 340 A1**
(43) Date of publication of application: **01.07.2026**
(21) Application number: 24223356.7
(22) Date of filing: 27.12.2024
(51) Int. Cl.: H10F 19/31, H10F 19/75

(54) **OPTOELECTRONIC COMPONENT HAVING OPTOELECTRONIC CELLS COMPRISING A CURRENT-CONTRIBUTING AREA AND A NON-CURRENT-CONTRIBUTING AREA**

(71) Applicant: Heliatek GmbH, 01139 Dresden (DE)
(72) Inventor: Berger, Ulf, 01139 Dresden (DE); Fischer, Simon, 01139 Dresden (DE); Friedrich-Schilling, Niels, 01139 Dresden (DE); Greifzu, Georg, 01139 Dresden (DE); Stanek, Bonnie, 01139 Dresden (DE); Widmer, Johannes, 01139 Dresden (DE)

(57) **Abstract**

The invention relates to an optoelectronic component (100) having at least two optoelectronic cells (1) being connected in series, each optoelectronic cell (1) comprises a current-contributing area (I) and at least one non-current-contributing area (II, III), wherein the at least one non-current-contributing area (II, III) and the current-contributing area (I) of the optoelectronic cell (1) share the same stack (10), wherein the at least one non-current-contributing area (II, III) is arranged within the current-contributing area (I) and is delimited from the current-contributing area (I) by separating structures, wherein the current-contributing area (I) and the at least one non-current-contributing area (II, III) of the optoelectronic cell (1) are electrically connected antiparallel to each other, wherein the stack (10) of each optoelectronic cell (1) is structured in such a way that a base electrode (11) of the current-contributing area (I) is electrically separated from a base electrode (11) of the at least one non-current-contributing area (II, III), and the base electrode (11) of the at least one non-current-contributing area (II, III) is electrically connected to a top electrode (12) of the current-contributing area (I).

## Description

The invention relates to an optoelectronic component for converting light into electrical energy with improved efficiency and service life in the case of partial shading. The optoelectronic component having at least two optoelectronic cells being connected in series, each optoelectronic cell comprises a current-contributing area and at least one non-current-contributing area, wherein the at least one non-current-contributing area and the current-contributing area of the optoelectronic cell share the same stack, wherein the at least one non-current-contributing area is arranged within the current-contributing area and is delimited from the current-contributing area by separating structures, and wherein the current-contributing area and the at least one non-current-contributing area of the optoelectronic cell are electrically connected antiparallel to each other.

Optoelectronic components, particularly photovoltaic elements or solar cells, that are integrated into or attached to a building structure can be partially or fully shaded. Optoelectronic components, in particular photovoltaic elements, or optoelectronic cells thereof, which are connected in series are not always shaded to the same extent but are still partly exposed to sunlight.

A problem occurring with serially interconnected optoelectronic cells when one or more individual optoelectronic cells are at least partially shaded is that the shaded optoelectronic cells form reverse-biased diodes with respect to the unshaded or less shaded optoelectronic cells connected in series. The shaded or partially shaded optoelectronic cells therefore impede the flow of photogenerated current, which has a negative effect on efficiency. In addition, there is a risk of concentrated current flow in the shaded optoelectronic cells through regions exhibiting local defects, which can lead to local overheating and eventually irreversible degradation of the optoelectronic cells, resulting in a loss of efficiency of the optoelectronic component comprising said optoelectronic cells. Methods known from the prior art for circumventing the problem of partial shading use bypass diodes to ensure the flow of current of optoelectronic cells connected in series and to avoid damage to the partly shaded optoelectronic cells. In the case of a shaded or defective optoelectronic cell, the power loss is reduced by connecting a bypass diode in parallel with the optoelectronic cells. In case an optoelectronic cell is shaded or at least partly shaded, it generates no voltage or a lower voltage, and the current generated by the optoelectronic cells connected in series upstream in the direction of current flow cannot be conducted and damages the at least partly shaded optoelectronic cell. In such a case, the bypass diode can take over the conduction of the generated current from optoelectronic cells connected upstream to optoelectronic cells connected downstream in direction of current flow through the bypass diode, thereby preventing damage to the shaded optoelectronic cell. However, such a solution is very costly and requires additional steps in manufacturing and/or integration of additional external components.

US 2015/0349164 Al discloses an integrated bypass diode in a solar cell, wherein the bypass diode and the solar cell comprise different regions alongside one another on the substrate and are completely electrically isolated by trenches, and the contacting is only affected subsequently.

Module level protection can be implemented at the junction box of each module shortcutting the whole module by means of a protective device in case of partial shading.

US 4460232 A discloses a junction box for mounting on a photovoltaic solar module providing means for connecting plug members to two discrete bus bars in said solar module and comprising a diode.

It is therefore an object of the invention to provide an optoelectronic component having at least two optoelectronic cells connected in series in which the disadvantages mentioned do not occur and in which, in particular, no failure of the complete optoelectronic component occurs in case of a single defective or non-working optoelectronic cell, e.g. in the event of partial shading, wherein in particular the manufacture of the optoelectronic component shall be cost-effective and can be integrated into the optoelectronic component manufacturing process without additional components.

The object is achieved by the subject of the independent claims. Advantageous configurations are apparent from the dependent claims.

The object of the present invention is in particular solved by an optoelectronic component having at least two optoelectronic cells, the at least two optoelectronic cells being connected in series, each optoelectronic cell having a stack comprising a base electrode, a top electrode and a photoactive layer arranged between the base electrode and the top electrode, wherein each optoelectronic cell comprises a current-contributing area and at least one non-current-contributing area, wherein the at least one non-current-contributing area and the current-contributing area of the optoelectronic cell share the same stack, wherein the at least one non-current-contributing area is arranged within the current-contributing area and is delimited from the current-contributing area by separating structures, wherein the current-contributing area and the at least one non-current-contributing area of the optoelectronic cell are electrically connected antiparallel to each other, and wherein the stack of each optoelectronic cell is structured in such a way that the base electrode of the current-contributing area is electrically separated from the base electrode of the at least one non-current-contributing area, and the base electrode of the at least one non-current-contributing area is electrically connected to the top electrode of the current-contributing area.

According to the invention, it is preferably provided that the optoelectronic component comprises a plurality of optoelectronic cells, wherein the optoelectronic cells of the optoelectronic component are arranged next to each other and connected in series. Preferably, each optoelectronic cell has its own base electrode and top electrode, in particular electrically connecting the base electrode of one optoelectronic cell to the top electrode of the next optoelectronic cell following in the direction of current flow. Due to the at least two optoelectronic cells being connected in series a current flow through the optoelectronic cells passes through the optoelectronic cells one after another. Thus, the current flows from one optoelectronic cell to an immediately neighboring optoelectronic cell. Optoelectronic cells that are located directly next to each other are considered to be neighboring optoelectronic cells.

A photoactive layer is in particular understood to be a layer which is capable of converting electric current into light emission or converting light incident on the photoactive layer into electric current. The photoactive layer preferably comprises a plurality of sublayers, in particular absorbing or emitting light of a distinct wavelength range, electron transport layers or hole transport layers.

A current-contributing area of an optoelectronic cell is in particular understood to be a part of the area of the optoelectronic cell in which an electric potential respective an electric current is generated when light is incident on the optoelectronic cell and contributes in an additive way to the total current of the cells connected in series.

A non-current-contributing area of an optoelectronic cell is in particular understood to be a part of the area of an optoelectronic cell in which no electric potential respective no electric current is generated when light is incident on the optoelectronic cell or, alternatively, in which an electric potential respective electric current of reverse polarity with respect to the electric potential respective electric current generated in the current-contributing area of the optoelectronic cell is generated when light is incident on the optoelectronic cell, thus, not contributing to the total current of the cells connected in series. Thus, the non-current-contributing area of an optoelectronic cell does not make a constructive contribution to the electric current generated by the optoelectronic cell when light is incident on the optoelectronic cell.

In a preferred embodiment, the at least one non-current-contributing area of an optoelectronic cell is located immediately next to the at least one non-current-contributing area of a neighboring optoelectronic cell.

The optoelectronic component according to the invention has advantages over the prior art. Advantageously, the optoelectronic component enables current generated in neighboring optoelectronic cells to pass through the optoelectronic cell in case of partial or complete shading of said optoelectronic cell. In particular, integrating non-current-contributing areas into the stack of the optoelectronic cell by structuring the stack using separating structures to introduce non-current-contributing areas within the current-contributing area in terms of process engineering and in terms of manufacturing is a simple procedure, and, moreover, cost-effective. Advantageously, no additional components, neither arranged external or internal of the optoelectronic component, for protecting individual optoelectronic cells are required. Advantageously, the current generated in the current-contributing area of the optoelectronic cell in case of working as intended under illumination does not pass through the non-current-contributing area, in particular, since the non-current-contributing area and the current-contributing area share the same stack and are electrically antiparallel connected to each other. Advantageously, the optoelectronic cells have a very homogeneous optical impression since the current-contributing area and the non-current-contributing area share the same stack and do not differ in terms of color.

According to a further development of the invention, it is provided that the at least one non-current-contributing area is separated in a counter region and a shortcut region by separating structures within the top electrode, wherein the shortcut region is located next to the counter region in the direction of current flow.

A shortcut region of the non-current-contributing area is in particular understood to be a region, in which by means of an electrically conductive connecting element a shortcut is created between the base electrode and top electrode in the non-current-contributing region of the photovoltaic cell. A counter region of the non-current-contributing area is in particular understood to be a region, in which a current generated by illumination flows in a reverse direction with respect to the current generated in the current-contributing area due to the stack being structured by separating structures in such a way that the counter region is electrically connected anti-parallel with respect to the current-contributing area. Thus, a current generated in the counter region contributes in a subtractive way to the electric current generated by the optoelectronic cell when light is incident on the optoelectronic cell.

In a preferred embodiment, the at least one non-current-contributing area is separated in a counter region and a shortcut region by separating structures within the top electrode as well as separating structures within the photoactive layer, wherein preferably the separating structures within the top electrode are arranged flush on top with the separating structures within the photoactive layer thereby forming a common separating structure within top electrode and photoactive layer.

According to a further development of the invention, it is provided that the base electrode of the current-contributing area and of the at least one non-current-contributing area of an optoelectronic cell is electrically separated from the base electrode of a neighboring optoelectronic cell by separating structures. In particular, the base electrode of the at least one non-current-contributing area of an optoelectronic cell is electrically separated from the base electrode of the current-contributing area as well as the base electrode of the at least one non-current-contributing area of a neighboring optoelectronic cell by separating structures.

According to a further development of the invention, it is provided that the top electrode of the counter region of the at least one non-current-contributing area of an optoelectronic cell is electrically connected to the top electrode of the neighboring optoelectronic cell preceding in the direction of current flow, wherein preferably the counter region of the at least one non-current-contributing area of an optoelectronic cell and the shortcut region of a neighboring optoelectronic cell preceding in the direction of current flow commonly share the top electrode.

In a preferred embodiment, the top electrode of the counter region of the at least one non-current-contributing area of the optoelectronic cell is electrically connected to the top electrode in an area of the shortcut region of the neighboring optoelectronic cell preceding in the direction of current flow.

According to a further development of the invention, it is provided that the shortcut region of the at least one non-current-contributing area of the optoelectronic cell and the current-contributing area of the optoelectronic cell commonly share the top electrode. Preferably there is one top electrode in the optoelectronic cell extending contiguously over the current-contributing area and the shortcut regions of the at least one non-current-contributing area of the optoelectronic cell.

According to a further development of the invention, it is provided that the top electrode of the current-contributing area of an optoelectronic cell is electrically connected to the base electrode of the current-contributing area of a neighboring optoelectronic cell following in the direction of current flow.

According to a further development of the invention, it is provided that each optoelectronic cell comprises at least two non-current-contributing areas, preferably comprises several non-current-contributing areas at a certain, preferably fixed, distance to each other in the longitudinal direction of the optoelectronic cell of the main extension plane of the optoelectronic cells. Integrating more than one non-current-contributing area into the current-contributing area of the optoelectronic cell is advantageous since the evolution of heat of many non-current-contributing areas can be dissipated more easily than for a single, maybe larger, non-current-contributing area.

In a preferred embodiment, all optoelectronic cells of the optoelectronic component comprise the same number of non-current-contributing areas, preferably the surface area of all non-current-contributing areas is the same. In a preferred embodiment, the certain distance of the non-current-contributing areas to each other in the longitudinal direction of the optoelectronic cell is the same in all optoelectronic cells.

A longitudinal direction of the optoelectronic cell is in particular understood to be the direction of the longest extent of the optoelectronic cell in the main extension plane of the optoelectronic cells.

According to a further development of the invention, it is provided that a separating structure of a first type (P1) electrically separates the base electrode of the current-contributing area from the base electrode of the at least one non-current-contributing area of the optoelectronic cell and from the base electrode of neighboring optoelectronic cells, a separating structure of a second type (P2) electrically separates the photoactive layer in the current-contributing area from the photoactive layer in the current-contributing area of a neighboring optoelectronic cell, and a separating structure of a third type (P3) electrically separates the top electrodes of the current-contributing area from the top electrode of the counter region of the optoelectronic cell and from the top electrodes of the current-contributing area of a neighboring optoelectronic cell, wherein the separating structure of the second type (P2) is preferably filled with material of the top electrode.

According to a further development of the invention, it is provided that the base electrode of the at least one non-current-contributing area of the optoelectronic cell is in at least one section, in particular partially or at some parts of the shortcut region, electrically connected to the top electrode of the immediately adjacent current-contributing area of the same optoelectronic cell by the top electrode extending into the separating structure of the second type (P2) located in the shortcut region forming at least one electrically conductive connecting element located within the shortcut region of the at least one non-current-contributing area.

According to a further development of the invention, it is provided that the at least one electrically conductive connecting element has a length greater than a width of the at least one non-current-contributing area in longitudinal direction of the optoelectronic cell, preferably the at least one electrically conductive connecting element in the main extension plane of the optoelectronic cell is essentially of zigzag, curved, buckled or wave-line shape.

In a preferred embodiment, the non-current-contributing area in the main extension plane of the optoelectronic cell has a rectangular, in particular quadratic, a polygonal, an oval or a circular shape.

According to a further development of the invention, it is provided that the shortcut region of the at least one non-current-contributing area of the optoelectronic cell comprises two or more electrically conductive connecting elements.

In a preferred embodiment, a sum of a surface area or a cross-sectional area of the two or more electrically conductive connecting elements is the same in all optoelectronic elements, preferably in all shortcut regions.

In a preferred embodiment, the shape in the main extension plane of the optoelectronic cell of the two or more electrically conductive connecting elements located in the same shortcut region is essentially identical, wherein preferably the two or more electrically conductive connecting elements are arranged essentially parallel to each other in the main extension plane of the optoelectronic cell.

According to a further development of the invention, it is provided that at least the counter region of the at least one non-current-contributing area on a light-receiving surface facing the light as intended is covered by a covering layer, preferably the covering layer having a transmittance of less than 20%, preferably of less than 10%, or preferably of less than 5%. Advantageously, parts of the non-current-contributing area which are covered by a covering layer do not generate electric current from incident light in that the current generated within the current contributing area of the optoelectronic cell when working as intended under illumination is not impaired by a reverse current generated within the at least one non-current-contributing area, in particular the counter region of the at least one non-current-contributing area of the optoelectronic cell.

According to a further development of the invention, it is provided that the optoelectronic cell has a continuous separating structure of the third type (P3) extending along the longitudinal direction of the optoelectronic cell, wherein the separating structure of the third type (P3) forms a bulge in the at least one non-current-contributing area in the direction of current flow, preferably the bulge has rectangular shape.

According to a further development of the invention, it is provided that a surface area of the surface in the main extension plane of the at least one non-current-contributing area of the optoelectronic cell is 2% to 20% of the total surface area of the surface in the main extension plane of the optoelectronic cell, preferably 2% to 10%, or preferably 2% to 5%.

According to a further development of the invention, it is provided that the photoactive layer is a light-absorbing layer and/or the optoelectronic component is a photovoltaic element.

In a preferred embodiment, the photoactive layer is forming a CIS, CIGS, GaAs, or Si cell, a perovskite cell or an organic photovoltaic element (OPV), a so-called organic solar cell. An organic photovoltaic element is understood to mean in particular a photovoltaic element having at least one organic photoactive layer, in particular a polymeric organic photovoltaic element or an organic photovoltaic element based on small molecules. Small molecules are understood to be in particular non-polymeric organic molecules with monodisperse molar masses between 100 and 2000 g/mol, which are present in solid phase under normal pressure (atmospheric pressure of the surrounding atmosphere) and at room temperature.

In a preferred embodiment, the optoelectronic component is a flexible optoelectronic component. A flexible optoelectronic component is understood to mean in particular an optoelectronic component which is bendable and/or extensible in a certain area.

The invention is explained in more detail below with reference to the figures.
Fig. 1 shows a schematic illustration of an embodiment of an optoelectronic component in a 3D-scheme and an exploded drawing;
Fig. 2 shows a schematic illustration of an embodiment of structured optoelectronic cells comprising a current-contributing area and a non-current-contributing area of an optoelectronic component in plan view and in cross-sectional view;
Fig. 3 shows a schematic illustration of an embodiment of a structured optoelectronic cell comprising a current-contributing area and a non-current-contributing area in plan view and in cross-sectional view;
Fig. 4 shows a schematic illustration of an embodiment of an optoelectronic component having several non-current-contributing areas in each optoelectronic cell in plan view; and
Fig. 5 shows schematic illustrations of various embodiments of electrically conductive connecting elements in the shortcut region of optoelectronic cells in plan view.

Identical and functionally identical elements are labelled with the same reference symbols, so that reference is made to the previous description. The proportions in the Figures are not to scale.

### Exemplary embodiments of the invention

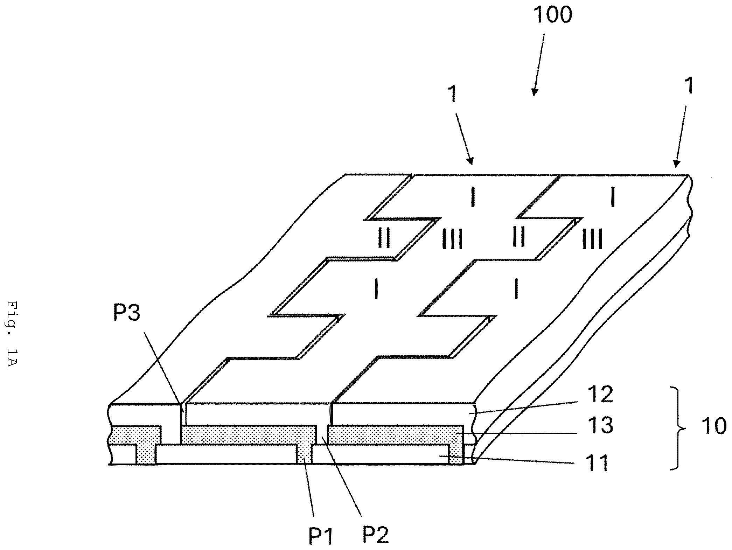

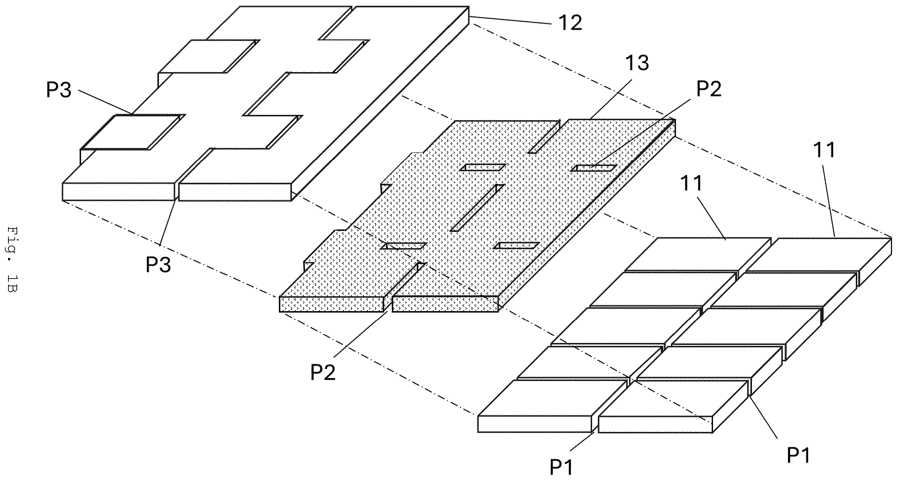

Fig. 1 shows a schematic illustration of an exemplary embodiment of an optoelectronic component 100 in a 3D-scheme (Fig. 1A) and an exploded drawing (Fig. 1B). In this exemplary embodiment the optoelectronic component 100 is a photovoltaic element.

The optoelectronic component 100 having at least two optoelectronic cells 1 being connected in series, each optoelectronic cell 1 having a stack 10 comprising a base electrode 11, a top electrode 12 and a photoactive layer 13 arranged between the base electrode 11 and the top electrode 12, wherein each optoelectronic cell 1 comprises a current-contributing area I and at least one non-current-contributing area II, III, wherein the at least one non-current-contributing area II, III and the current-contributing area I of the optoelectronic cell 1 share the same stack 10. The at least one non-current-contributing area II, III is arranged within the current-contributing area I and is delimited from the current-contributing area I by separating structures, wherein the current-contributing area I and the at least one non-current-contributing area II, III of the optoelectronic cell 1 are electrically connected antiparallel to each other. The stack 10 is structured in such a way that the base electrode 11 of the current-contributing area I is electrically separated from the base electrode 11 of the at least one non-current-contributing area II, III, and the base electrode 11 of the at least one non-current-contributing area II, III is electrically connected to the top electrode 12 of the current-contributing area I.

The optoelectronic component 100 of Fig. 1A shows a section of two optoelectronic cells 1, however, the optoelectronic component 100 may comprise a plurality of optoelectronic cells 1 connected in series. The base electrode 11 of optoelectronic cells 1 is structured by separating structures of a first type P1. The photoactive layer 13 of the optoelectronic cells 1 is structured by separating structures of a second type P2. The top electrode 12 of optoelectronic cells 1 is structured by separating structures of a third type P3. In a further embodiment of the invention the photoactive layer 13 is formed by a plurality of sublayers comprising photoactive sublayers, electron transport layers and hole transport layers.

In Fig. 1B, the optoelectronic component 100 of Fig. 1A is shown in an exploded drawing of a section showing the base electrode 11 with structuring of the first type (P1), a section showing the photoactive layer 13 with structuring of the second type (P2), and a section showing the top electrode 12 with structuring of the third type (P3).

In an exemplary embodiment the optoelectronic component 100 is prepared as follows: A layer of metal in a layer thickness of 50 nm is deposited as base electrode 11 onto a transparent substrate (not depicted). Alternatively, a transparent conductive oxide may be used as base electrode 11. The base electrode 11 is structured by laser-structuring to get separating structures of the first type P1. In this example rectangular structures are separated from each other by a separating structure of the first type P1 forming the base electrode layer 11 shown in Fig. 1B. The photoactive layer 13 is deposited onto the base electrode 11. The deposition of the photoactive layer 13 may be performed in several steps in order to grow a plurality of sublayers constituting the photoactive layer 13. Deposition of the photoactive layer 13 may be performed using standard methods like sputtering, chemical vapor deposition (CVD), physical vapor deposition (PVD), or deposition from solution. The photoactive layer 13 is structured using laser-structuring, electron beam structuring, etching using photo masks, etc.

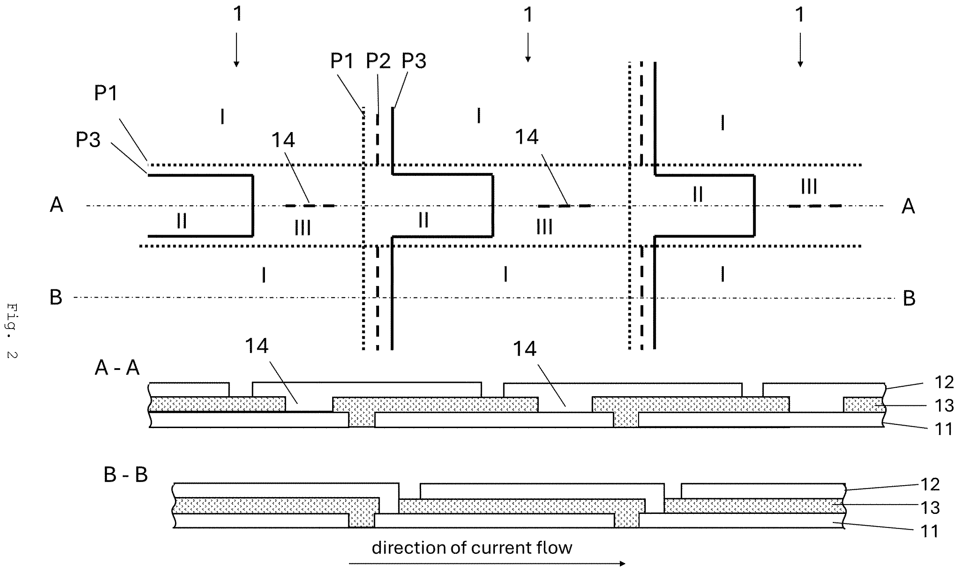

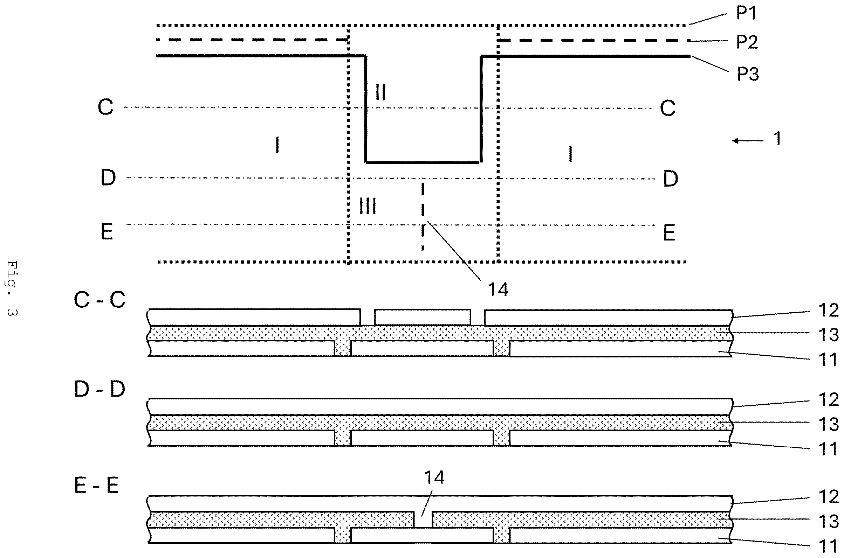

Structuring is performed to create an interrupted line of separating structures of the second type P2 in a longitudinal direction of the optoelectronic cell 1. The line of separating structures of the second type P2 is interrupted at the points where the counter-regions II are to be created. Moreover, these separating structures of the second type P2 are created at a distance parallel to the separating structures of the first type P1 running in longitudinal direction of the optoelectronic cell 1. Additional separating structures of the second type P2 are created in the region where the shortcut-region III of the non-current-contributing areas II, III are to be manufactured. According to the embodiment shown in Fig. 2, these separating structures of the second type P2 are perpendicular to the longitudinal direction of the optoelectronic cell 1. The top electrode 12, e.g. Aluminum, is sputtered or evaporated onto the photoactive layer 13. The separating structures of the second type P2 of the photoactive layer 13 are filled with material of the top electrode 12 in each case creating an electrically conductive connection between top electrode 12 and base electrodes 11. The deposited top electrode 12 is structured by laser structuring, electron beam structuring, etching using photo masks, etc. By structuring a continuous separating structure of the third type P3 extending along the longitudinal direction of the optoelectronic cell 1 is formed, wherein the separating structure of the third type P3 forms a bulge in the at least one non-current-contributing area II, III separating a counter region II and a shortcut-region III within each optoelectronic cell 1 (see Fig. 2/3). In this embodiment the bulge has rectangular shape and runs parallel at a distance to the separating structure of the second type P2.

Fig. 2 shows a schematic illustration of an embodiment of structured optoelectronic cells 1 comprising a current-contributing area I and a non-current-contributing area II,III of an optoelectronic component 100 in plan view and in cross-sectional view.

In the cross-sectional view of Fig. 2 cross sections along A-A and B-B are depicted. The scale is the same for the plan view and the cross sections in that the separating structures depicted in the plan view coincide with the separating structures depicted in the cross-sectional views. Cross-section along A-A demonstrates the structured stack 10 within the non-current-contributing area II, III and cross-section B-B demonstrates the structured stack 10 within the current-contributing area I. The lines for the cross-sectional views A-A and B-B are indicated in the plan view each by a thin dash dot line.

The at least one non-current-contributing area II, III of the optoelectronic cell 1 is separated in a counter region II and a shortcut region III by separating structure P3 within the top electrode 12, wherein the shortcut region III is located next to the counter region II in the direction of current flow.

Separating structures of a first type P1 electrically separate the base electrode 11 of the current-contributing area I from the base electrode 11 of the at least one non-current-contributing area II, III of the optoelectronic cell 1 and from the base electrodes 11 of neighboring optoelectronic cells 1. Separating structures of a second type P2 electrically separate the photoactive layer 13 in the current-contributing area I from the photoactive layer 13 in the current-contributing area I of a neighboring optoelectronic cell 1. Separating structures of a third type P3 electrically separate the top electrode 12 of the current-contributing area I from the top electrode 12 of the counter region II of the optoelectronic cell 1 and from the top electrode 12 of the current-contributing area I and the shortcut region I of a neighboring optoelectronic cell 1. In this embodiment, the separating structures of the second type P2 are filled with material of the top electrode 12.

In this embodiment the base electrode 11 of the current-contributing area I and of the at least one non-current-contributing area II, III of an optoelectronic cell 1 is electrically separated from the base electrode 11 of a neighboring optoelectronic cell 1, in particular of the at least one non-current-contributing area II, III and of the current-contributing area, by separating structures of the first type P1.

As shown in Fig. 2, the top electrode 12 of the counter region II of the at least one non-current-contributing area II, III of an optoelectronic cell 1 is electrically connected to the top electrode 12 of the neighboring optoelectronic cell 1 preceding in the direction of current flow, wherein the counter region II of the at least one non-current-contributing area II, III of an optoelectronic cell 1 and the shortcut region III of a neighboring optoelectronic cell 1 preceding in the direction of current flow commonly share the top electrode 12. The direction of current flow in the embodiment shown in Fig. 2 is from the left hand side to the right hand side.

In this embodiment the shortcut region III of the at least one non-current-contributing area II, III of the optoelectronic cell 1 and the current-contributing area I of the optoelectronic cell 1 commonly share the top electrode 12, there is no separating structure of the third type P3 between.

The cross-sectional view B-B shows that the top electrode 12 of the current-contributing area I of an optoelectronic cell 1 is electrically connected to the base electrode 11 of the current-contributing area I of a neighboring optoelectronic cell 1 in the direction of current flow.

As shown in Fig. 2, the base electrode 11 of the at least one non-current-contributing area II, III of the optoelectronic cell 1 is in at least one section, at parts between the base electrode 11 and the top electrode 12, electrically connected to the top electrode 12 of the immediately adjacent current-contributing area I of the same optoelectronic cell 1 by the top electrode 12 extending into the separating structure of the second type P2 located within the shortcut region III forming at least one electrically conductive connecting element 14 located within the shortcut region III of the at least one non-current-contributing area II, III.

Fig. 3 shows a schematic illustration of an embodiment of a structured optoelectronic cell 1 comprising a current-contributing area I and a non-current-contributing area II, III in plan view and in cross-sectional view.

Cross-section C-C demonstrates within one optoelectronic cell 1 the structured stack 10 along the current-contributing area I and the counter region II of the non-current-contributing area II, III. Cross-section D-D demonstrates within one optoelectronic cell 1 the structured stack 10 along the current-contributing area I and the shortcut region III of the non-current-contributing area II, III. Cross-section E-E demonstrates within one optoelectronic cell 1 the structured stack 10 along the current-contributing area I and the shortcut region III of the non-current-contributing area II, III having an electrically conductive connecting element 14. The scale for the three cross-sectional views along lines C-C, D-D and E-E is the same as for the plan view in that the separating structures depicted in the plan view coincide with the separating structures depicted in the cross-sectional views.

The shortcut region III comprises a separating structure of the second type P2 being filled with material of the top electrode 12 which is forming an electrically conductive connecting element 14 located within the shortcut region III of the at least one non-current-contributing area II, III. In this embodiment the electrically conductive connecting element 14 has a straight linear shape with a direction essentially perpendicular to the main extension plane of the optoelectronic cell 1. The electrically conductive connecting element 14 electrically connects the top electrode 12 to the base electrode 11 in the shortcut region III, as becomes evident from cross sectional view E-E.

In one configuration of the invention, the counter region II of the at least one non-current-contributing area II, III on a light-receiving surface facing the light as intended is covered by a covering layer, preferably the covering layer having a transmittance of less than 20%, or preferably of less than 5%. This prevents that by irradiation of the photovoltaic module 100 a simultaneously irradiated counter region II would generate a counter current reducing the efficiency of the photovoltaic module 100.

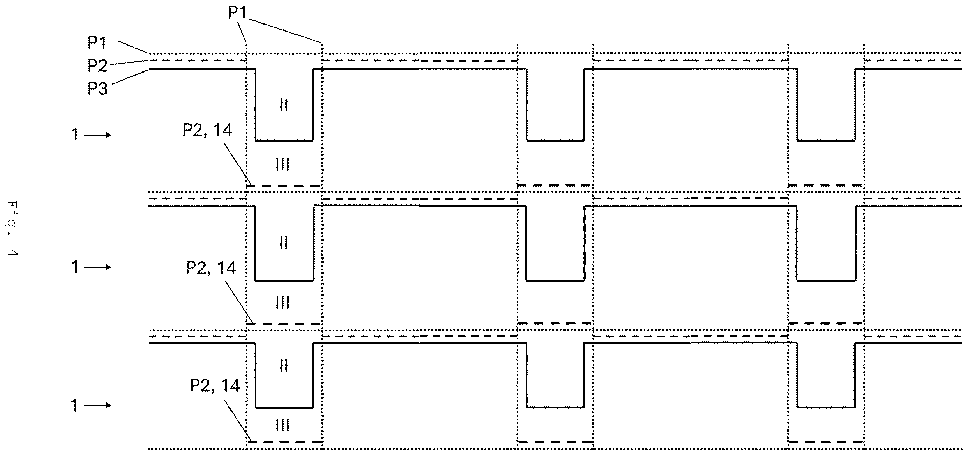

Fig. 4 shows a schematic illustration of an embodiment of an optoelectronic component 100 having several non-current-contributing areas II, III in each optoelectronic cell 1 in plan view. In this exemplary embodiment of the optoelectronic component 100 three optoelectronic cells 1 are connected in series.

Each optoelectronic cell 1 comprises a plurality of non-current-contributing areas II, III. The non-current-contributing areas II, III are arranged in a certain distance to each other on the longitudinal direction of the optoelectronic cell 1.

In this embodiment the electrically conductive connecting element 14 in plan view exhibits a straight linear shape with a direction parallel to the main extension direction of the optoelectronic cell 1. Furthermore, each optoelectronic cell 1 has a continuous separating structure of the third type P3 extending along the longitudinal direction of the optoelectronic cell 1, wherein the separating structure of the third type P3 forms a bulge in the at least one non-current-contributing area II, III in the direction of current flow. In this embodiment the bulge has rectangular shape.

In one configuration of the invention, a surface area of the surface in the main extension plane of the at least one non-current-contributing area II, III of the optoelectronic cell 1 is 2% to 10% of total surface area of the surface in the main extension plane of the optoelectronic cell 1.

In one configuration of the invention (not demonstrated), the shortcut region III of the at least one non-current-contributing area II, III of the optoelectronic cell 1 comprises two or more electrically conductive connecting elements 14.

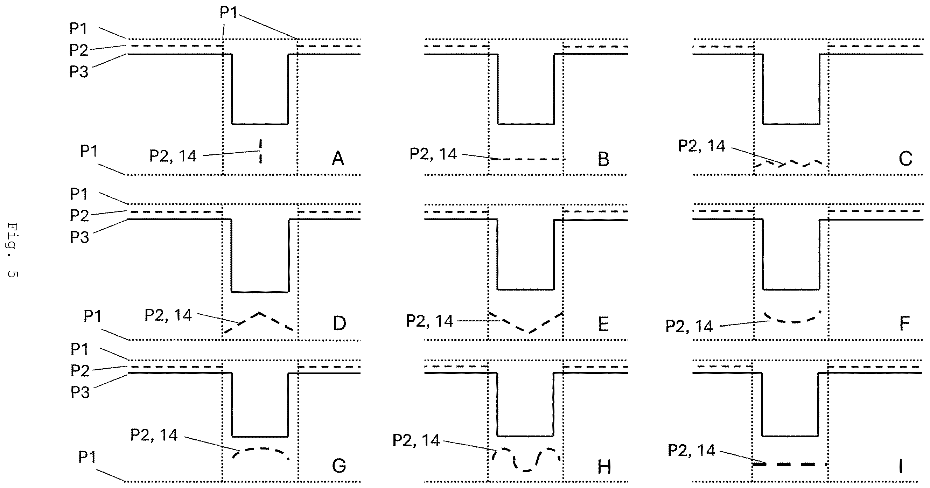

Fig. 5 shows schematic illustrations of various embodiments A to I of electrically conductive connecting elements 14 in the shortcut region III of optoelectronic cells 1 in plan view.

In embodiments A to I, the electrically conductive connecting element 14 of the shortcut region III of a non-current-contributing area II, III of an optoelectronic cell 1 is designed in different shape. Embodiment A is the same as shown in Fig. 3, and embodiment B is the same as shown in Fig. 4.

In embodiments C to H, the electrically conductive connecting element 14 has a length greater than the width of the non-current-contributing area II, III in longitudinal direction of the optoelectronic cell 1.

The electrically conductive connecting element 14 in the main extension plane of the optoelectronic cell 1 might be of different shape, preferably zigzag (embodiment C), curved (embodiments F, G), buckled (embodiments D, E), or wave-line shape (embodiment H). Embodiment I exemplifies an electrically conductive connecting element 14 having a thick line, i.e. having a comparatively large width in a direction perpendicular to its longitudinal extension compared to the exemplary embodiment shown in embodiment B.

## Claims

1. Optoelectronic component (100) having at least two optoelectronic cells (1), the at least two optoelectronic cells (1) being connected in series, each optoelectronic cell (1) having a stack (10) comprising a base electrode (11), a top electrode (12) and a photoactive layer (13) arranged between the base electrode (11) and the top electrode (12), wherein each optoelectronic cell (1) comprises a current-contributing area (I) and at least one non-current-contributing area (II, III), wherein the at least one non-current-contributing area (II, III) and the current-contributing area (I) of the optoelectronic cell (1) share the same stack (10), wherein the at least one non-current-contributing area (II, III) is arranged within the current-contributing area (I) and is delimited from the current-contributing area (I) by separating structures, wherein the current-contributing area (I) and the at least one non-current-contributing area (II, III) of the optoelectronic cell (1) are electrically connected antiparallel to each other, and wherein the stack (10) of each optoelectronic cell (1) is structured in such a way that the base electrode (11) of the current-contributing area (I) is electrically separated from the base electrode (11) of the at least one non-current-contributing area (II, III), and the base electrode (11) of the at least one non-current-contributing area (II, III) is electrically connected to the top electrode (12) of the current-contributing area (I).

2. Optoelectronic component (100) according to claim 1, wherein the at least one non-current-contributing area (II, III) is separated in a counter region (II) and a shortcut region (III) by separating structures within the top electrode (12), wherein the shortcut region (III) is located next to the counter region (II) in the direction of current flow.

3. Optoelectronic component (100) according to claim 1 or 2, wherein the base electrode (11) of the current-contributing area (I) and of the at least one non-current-contributing area (II, III) of an optoelectronic cell (1) is electrically separated from the base electrode (11) of a neighboring optoelectronic cell (1) by separating structures.

4. Optoelectronic component (100) according to claim 2 or 3, wherein the top electrode (12) of the counter region (II) of the at least one non-current-contributing area (II, III) of an optoelectronic cell (1) is electrically connected to the top electrode (12) of the neighboring optoelectronic cell (1) preceding in the direction of current flow, wherein preferably the counter region (II) of the at least one non-current-contributing area (II, III) of an optoelectronic cell (1) and the shortcut region (III) of a neighboring optoelectronic cell (1) preceding in the direction of current flow commonly share the top electrode (12).

5. Optoelectronic component (100) according to any one of claims 2 to 4, wherein the shortcut region (III) of the at least one non-current-contributing area (II, III) of the optoelectronic cell (1) and the current-contributing area (I) of the optoelectronic cell (1) commonly share the top electrode (12).

6. Optoelectronic component (100) according to any one of the preceding claims, wherein the top electrode (12) of the current-contributing area (I) of an optoelectronic cell (1) is electrically connected to the base electrode (11) of the current-contributing area (I) of a neighboring optoelectronic cell (1) following in the direction of current flow.

7. Optoelectronic component (100) according to any one of the preceding claims, wherein each optoelectronic cell (1) comprises at least two non-current-contributing areas (II, III), preferably comprises non-current-contributing areas (II, III) in a certain distance to each other in the longitudinal direction of the optoelectronic cell (1).

8. Optoelectronic component (100) according to any one of claims 2 to 7, wherein a separating structure of a first type (P1) electrically separates the base electrode (11) of the current-contributing area (I) from the base electrode (11) of the at least one non-current-contributing area (II, III) of the optoelectronic cell (1) and from the base electrode (11) of neighboring optoelectronic cells (1), a separating structure of a second type (P2) electrically separates the photoactive layer (13) in the current-contributing area (I) from the photoactive layer (13) in the current-contributing area (I) of neighboring optoelectronic cells (1), and a separating structure of a third type (P3) electrically separates the top electrode (12) of the current-contributing area (I) from the top electrode (12) of the counter region (II) of the optoelectronic cell (1) and from the top electrode (12) of the current-contributing area (I) of a neighboring optoelectronic cell (1), wherein preferably the separating structure of the second type (P2) is filled with material of the top electrode (12) .

9. Optoelectronic component (100) according to claim 8, wherein the base electrode (11) of the at least one non-current-contributing area (II, III) of the optoelectronic cell (1) is in at least one section electrically connected to the top electrode (12) of the immediately adjacent current-contributing area (I) of the same optoelectronic cell (1) by the top electrode (12) extending into the separating structure of the second type (P2) forming at least one electrically conductive connecting element (14) located within the shortcut region (III) of the at least one non-current-contributing area (II, III).

10. Optoelectronic component (100) according to claim 9, wherein the at least one electrically conductive connecting element (14) has a length greater than a width of the at least one non-current-contributing area (II, III) in longitudinal direction of the optoelectronic cell (1), preferably the at least one electrically conductive connecting element (14) in the main extension plane of the optoelectronic cell (1) is essentially of zigzag, curved, buckled or wave-line shape.

11. Optoelectronic component (100) according to claim 9 or 10, wherein the shortcut region (III) of the at least one non-current-contributing area (II, III) of the optoelectronic cell (1) comprises two or more electrically conductive connecting elements (14).

12. Optoelectronic component (100) according to any one of the preceding claims, wherein at least the counter region (II) of the at least one non-current-contributing area (II, III) on a light-receiving surface facing the light as intended is covered by a covering layer, preferably the covering layer having a transmittance of less than 20%, preferably of less than 10%, or preferably of less than 5%.

13. Optoelectronic component (100) according to claim 7, wherein the optoelectronic cell (1) has a continuous separating structure of the third type (P3) extending along the longitudinal direction of the optoelectronic cell (1), wherein the separating structure of the third type (P3) forms a bulge in the at least one non-current-contributing area (II, III) in the direction of current flow, preferably the bulge has rectangular shape.

14. Optoelectronic component (100) according to any one of the preceding claims, wherein a surface area of the surface in the main extension plane of the at least one non-current-contributing area (II, III) of the optoelectronic cell (1) is 2% to 20% of the total surface area of the surface in the main extension plane of the optoelectronic cell (1), preferably 2% to 10%, or preferably 2% to 5%.

15. Optoelectronic component (100) according to any one of the preceding claims, wherein the photoactive layer (13) is a light-absorbing layer and/or the optoelectronic component (100) is a photovoltaic element.
